# EUROPEAN PATENT APPLICATION

(11) **EP 4 815 030 A1**
(43) Date of publication of application: **30.09.2026**
(21) Application number: 24893941.5
(22) Date of filing: 28.10.2024
(51) Int. Cl.: H01L 21/02, C30B 29/04, C30B 29/06, C30B 29/16, C30B 29/36, C30B 29/38, C30B 33/06, H01L 21/20, H01L 21/265, H05H 1/24

(54) **BONDED SEMICONDUCTOR SUBSTRATE AND METHOD FOR MANUFACTURING BONDED SEMICONDUCTOR SUBSTRATE**

(30) Priority: 22.11.2023 JP 2023198240
(71) Applicant: SUMITOMO METAL MINING CO., LTD., Tokyo 105-8716 (JP)
(72) Inventor: UCHIDA, Hidetsugu, Tokyo 105-0004 (JP); KOBAYASHI, Motoki, Tokyo 105-0004 (JP)
(74) Representative: TBK
(86) International application number: PCT/JP2024/038313
(87) International publication number: WO 2025/109948

(57) **Abstract**

Provided are a bonded semiconductor substrate and a method for manufacturing the bonded semiconductor substrate that can prevent peeling of the substrates from the bonded interface of the bonded semiconductor substrates.

A method for manufacturing a bonded semiconductor substrate comprising a first semiconductor substrate and a second semiconductor substrate in contact with the first semiconductor substrate, comprising: an amorphous layer forming step of forming an amorphous layer on at least one of a first bonding target surface, which is the surface of the first semiconductor substrate where the first semiconductor substrate is bonded to the second semiconductor substrate, or a second bonding target surface, which is the surface of the second semiconductor substrate where the second semiconductor substrate is bonded to the first semiconductor substrate; a bonding step of bonding the first bonding target surface and the second bonding target surface to form a bonded substrate having a bonded interface; and a heat treatment step of heat treating the bonded substrate to set the height of an undulation at the bonded interface to 1.5 nm or more, wherein the thickness of the amorphous layer formed in the amorphous layer forming step is 5 nm or more.

## Description

### Technical Field

The present invention relates to a bonded semiconductor substrate, in which two or more substrates are bonded together via a bonded interface, and a method for manufacturing the bonded semiconductor substrate, which can prevent delamination at the bonded interface.

### Background Art

As an example of manufacturing a bonded semiconductor substrate, a technique of bonding a SiC single crystal substrate and a SiC polycrystalline substrate is known. Related techniques include the technique disclosed in Patent Literature 1.

### Citation List

### Patent Literature

Patent Literature 1: JP 6061251 B

### Summary of the Invention

### Problem to be Solved by the Invention

When a SiC single crystal substrate and a SiC polycrystalline substrate are directly bonded together, there is a risk of delamination at the bonded interface even with a small impact if the bonding strength at the bonded interface is low. For example, if delamination occurs at the bonded interface of the bonded semiconductor substrates inside a growth furnace for growing an epitaxial film on the surface of a SiC single crystal substrate of a bonded semiconductor substrate, or inside a device manufacturing apparatus for manufacturing semiconductor devices using the bonded semiconductor substrates after the epitaxial film has been formed, dust generation can occur inside the furnace or apparatus, causing the growth furnace or apparatus to stop operating due to dust generation, or reducing the operating rate of the growth furnace or apparatus due to cleaning or other operations, resulting in a decrease in production efficiency, which is undesirable.

In the semiconductor substrate manufacturing method of Patent Literature 1, an amorphous layer is formed on the surface of a support substrate and a single-crystalline layer before they are brought into contact and then heat-treated to achieve a bonding strength strong enough to withstand semiconductor processing. This method is expected to suppress delamination at the bonded interface during the process of growing an epitaxial film on the bonded semiconductor substrate and then manufacturing a semiconductor device.

However, semiconductor devices formed with electronic circuits and cut into chips may be subjected to greater shocks after being incorporated into mobile phones, home appliances, and industrial equipment than the shocks they receive during the process of manufacturing semiconductor devices. It is important that delamination does not occur at the bonded interface of the bonded semiconductor substrate even when subjected to such large shocks.

Therefore, to solve the above problems, the object of the present invention is to provide a bonded semiconductor substrate and a method for manufacturing the bonded semiconductor substrate that can prevent delamination of the substrates from the bonded interface of the bonded semiconductor substrate.

### Solution to Problem

To solve the above problems, the present invention provides a bonded semiconductor substrate comprising a first semiconductor substrate and a second semiconductor substrate bonded to the first semiconductor substrate via a bonded interface, wherein the height of an undulation at the bonded interface is 1.5 nm or more.

The fracture strength in a stud-pull test in a direction perpendicular to the bonded interface may be 70 MPa or more.

The first semiconductor substrate and the second semiconductor substrate may be made of any of silicon carbide (SiC), silicon (Si), carbon (C), gallium nitride (GaN), aluminum nitride (AlN), gallium oxide (Ga₂O₃), and diamond.

The first semiconductor substrate may be a single-crystal silicon carbide substrate, and the second semiconductor substrate may be a polycrystalline silicon carbide substrate.

To solve the above-mentioned problems, the present invention provides a method for manufacturing a bonded semiconductor substrate comprising a first semiconductor substrate and a second semiconductor substrate in contact with the first semiconductor substrate, comprising: an amorphous layer forming step of forming an amorphous layer on at least one of a first bonding target surface, which is the surface of the first semiconductor substrate where the first semiconductor substrate is bonded to the second semiconductor substrate, or a second bonding target surface, which is the surface of the second semiconductor substrate where the second semiconductor substrate is bonded to the first semiconductor substrate, a bonding step of bonding the first bonding target surface and the second bonding target surface to form a bonded substrate having a bonded interface, and a heat treatment step of heat treating the bonded substrate to set the height of an undulation at the bonded interface to 1.5 nm or more, wherein the thickness of the amorphous layer formed in the amorphous layer forming step is 5 nm or more.

The first semiconductor substrate and the second semiconductor substrate may be any of silicon carbide (SiC), silicon (Si), carbon (C), gallium nitride (GaN), aluminum nitride (AlN), gallium oxide (Ga₂O₃), and diamond.

The amorphous layer may contain at least any of silicon (Si), carbon (C), helium (He), neon (Ne), argon (Ar), xenon (Xe), hydrogen (H), nitrogen (N), phosphorus (P), boron (B), and aluminum (Al).

The amorphous layer forming step may be a step of forming the amorphous layer by performing a plasma impantation step on at least one of the surface of the first bonding target surface or the surface of the second bonding target surface.

The heat treatment step may be a step of maintaining the temperature of the bonded substrate at 1100°C to 2200°C.

The method may comprise an ion implantation step of implanting hydrogen ions or helium ions into the first bonding surface to form an ion-implanted layer inside the first semiconductor substrate before or after the amorphous layer formation step.

The method may comprise a peeling step after the bonding step and before the heat treatment step, wherein the peeling step is a step of delaminating a portion of the first semiconductor substrate by using a microbubble layer as a peeling surface, wherein the microbubble layer is formed by heating the ion-implanted layer.

### Effects Of the Invention

The present invention provides a bonded semiconductor substrate and a method for manufacturing the bonded semiconductor substrate that can prevent the occurrence of substrate delamination from the bonded interface of the bonded semiconductor substrate.

### Brief Description of the Drawings

[Figure 1] A flow diagram illustrating an example of a method for manufacturing a bonded semiconductor substrate of the present invention.
[Figure 2] A schematic perspective view illustrating an example of a bonded semiconductor substrate of the present invention.
[Figure 3] A schematic side view of a single crystal substrate after formation of a hydrogen-implanted layer according to the present invention.
[Figure 4] A schematic side view of a single crystal substrate after formation of an amorphous layer according to the present invention.
[Figure 5] An explanatory diagram illustrating an example of an irradiation step according to the present invention.
[Figure 6] A schematic side view illustrating an example of a state in which a single crystal substrate with a hydrogen-implanted layer and an amorphous layer formed thereon is bonded to a support substrate.
[Figure 7] A schematic side view of an example of a bonded substrate according to the present invention.
[Figure 8A] A TEM image (in the Miller index [1-100] direction) of a cross section of a single crystal substrate on which an amorphous layer has been formed by implanting nitrogen-based plasma.
[Figure 8B] A TEM image (in the Miller index [1-100] direction) of a cross section of a single crystal substrate on which an amorphous layer has been formed by implanting nitrogen-based plasma.
[Figure 8C] A TEM image (in the Miller index [1-100] direction) of a cross section of a single crystal substrate on which an amorphous layer has been formed by implanting nitrogen-based plasma.
[Figure 9A] A TEM image (in the Miller index [1-100] direction) of a cross section of a single crystal substrate on which an amorphous layer has been formed by injecting phosphorus-based plasma.
[Figure 9B] A TEM image (in the Miller index [1-100] direction) of a cross section of a single crystal substrate on which an amorphous layer has been formed by injecting phosphorus-based plasma.
[Figure 9C] A TEM image (in the Miller index [1-100] direction) of a cross section of a single crystal substrate on which an amorphous layer has been formed by injecting phosphorus-based plasma.
[Figure 10] A TEM image (in the Miller index [1-100] direction) of a cross section of the bonded interface of a bonded semiconductor substrate of the present invention.
[Figure 11] A schematic side view showing a state in which a bonded semiconductor substrate and a stud pin are bonded with an adhesive when a stud-pull test is performed.

### Detailed Description of Embodiments

The present specification discloses a bonded semiconductor substrate and a method for manufacturing the bonded semiconductor substrate. This bonded semiconductor substrate is obtained by bonding a first semiconductor substrate and a second semiconductor substrate. It can be manufactured by amorphizing either or both of the bonding surfaces of the first semiconductor substrate and the second semiconductor substrate to form an amorphous layer (amorphous layer forming step), then bonding the amorphous layer of the first semiconductor substrate to the amorphous layer of the second semiconductor substrate (bonding step) to create a bonded substrate having a bonded interface, and then performing a heat treatment (heat treatment step) to form an undulating bonded interface.

If two semiconductor substrates are directly bonded together without forming an amorphous layer, even a small impact applied to the bonded substrate may cause the bonded substrate to delaminate at the bonded interface if the bonding strength at the bonded interface is low. To prevent this delamination, one or both of the bonding surfaces of the first semiconductor substrate and the second semiconductor substrate are made amorphous, allowing the atoms to constitute the semiconductor to move more easily in the amorphous layer. Then, by bonding the amorphous layers to form an undulating bonded interface, the bonding area between the first and second semiconductor substrates at the bonded interface is increased, thereby strengthening the bonding strength and preventing delamination at the bonded interface of the bonded semiconductor substrate.

An example of an embodiment of the present invention is described below with reference to the drawings.

### [Bonded Semiconductor Substrate]

A bonded semiconductor substrate includes a first semiconductor substrate and a second semiconductor substrate. The first semiconductor substrate and the second semiconductor substrate are bonded via a bonded interface.

### <Configuration of the Bonded Semiconductor Substrate>

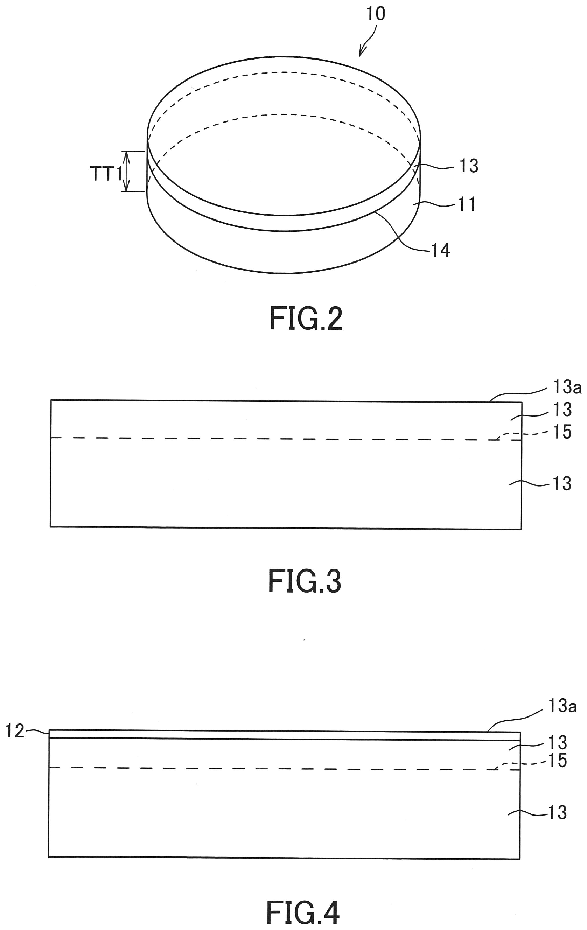

Figure 2 is a schematic perspective view illustrating an example of a bonded semiconductor substrate of the present invention. The bonded semiconductor substrate 10 of the present invention is formed, for example, in a disk shape with an orientation flat. Note that the shape is not limited to a disk (wafer shape) and may be polygonal. Bonded semiconductor substrate 10 shown in FIG. 2 includes single crystal substrate 13, which is an example of a first semiconductor substrate, and support substrate 11, which is an example of a second semiconductor substrate. Single crystal substrate 13 is bonded to support substrate 11 to form bonded interface 14.

Single crystal substrate 13 may be, for example, any of a compound semiconductor (e.g., silicon carbide (SiC), gallium nitride (GaN), aluminum nitride (AlN), gallium oxide (Ga₂O₃)), a single-element semiconductor (e.g., silicon (Si), carbon (C)), and diamond. These elements are semiconductor materials that can be used to fabricate semiconductor devices. Note that carbon (C) is not diamond, and may be, for example, graphite.

Various materials can be used for the support substrate 11. It is preferable that the support substrate 11 be resistant to the various thermal steps applied to the single crystal substrate 13. It is also preferable that the support substrate 11 be made of a material with a small difference in thermal expansion coefficient from the single crystal substrate 13. For example, the support substrate 11 can be made of any of silicon carbide (SiC), silicon (Si), carbon (C), gallium nitride (GaN), aluminum nitride (AlN), gallium oxide (Ga₂O₃), diamond, sapphire (Al₂O₃), and quartz (SiO₂).

For example, the single crystal substrate 13, which is an example of a first semiconductor substrate, may be a single crystal silicon carbide substrate (a SiC single crystal substrate), and the support substrate 11, which is an example of a second semiconductor substrate, may be a polycrystalline silicon carbide substrate (a SiC polycrystalline substrate).

The SiC single crystal substrate may be a 4H-SiC single crystal substrate fabricated by, for example, sublimation. The SiC single crystal substrate may be, for example, substantially disc-shaped with an orientation flat and a diameter of 4 to 8 inches. The shape is not limited to a disc (wafer) shape and may also be polygonal.

The SiC polycrystalline substrate may also contain a mixture of SiC crystals of various polytypes and plane orientations. A SiC polycrystalline substrate with a mixture of various polytypes and plane orientations can be manufactured without strict temperature control, thereby reducing the cost of manufacturing the support substrate 11. For example, a 3C-SiC polycrystalline substrate obtained by depositing a SiC polycrystalline film by chemical vapor deposition may be used. The SiC polycrystalline substrate may have a shape like that of the SiC single crystal substrate, for example, a substantially disc-shaped substrate with an orientation flat and a diameter of 4 to 8 inches. The shape is not limited to a disc shape and may also be polygonal.

The thickness TT1 of the support substrate 11 may be determined so as to provide sufficient mechanical strength to withstand subsequent processing steps, such as the formation of an epitaxial layer and the subsequent formation of semiconductor elements and devices thereon. For example, if the diameter of the support substrate 11 is 6 inches (150 mm), the thickness TT1 may be approximately 350 µm. A substrate with a thickness TT1 of 300 to 500 µm can be used.

### (Fracture Strength)

The bonded semiconductor substrate preferably has a fracture strength of 70 MPa or more in a stud-pull test in a direction perpendicular to the bonded interface. In the examples described below, the fracture strength of the SiC single crystal substrate alone measured by the stud-pull test was less than 70 MPa. In other words, a fracture strength of 70 MPa or more indicates that the bonded semiconductor substrate has such a strong bond that it will not peel off at the bonded interface even if the fracture strength is less than 70 MPa.

A fracture strength of 70 MPa or more in a stud-pull test can prevent delamination at the bonded interface during the process of growing an epitaxial film on the bonded semiconductor substrate and then manufacturing a semiconductor device. It can also prevent delamination at the bonded interface even after electronic circuits are formed on the substrate, the substrate is cut into chips, and the chips are incorporated into mobile phones, home appliances, and industrial equipment.

A fracture strength of 70 MPa or more in a stud-pull test can prevent delamination at the bonded interface. As described below, there is no particular upper limit to the fracture strength because the adhesive may cause breakage. However, when the bonded semiconductor substrate is a substrate formed by bonding a SiC single crystal substrate and a SiC polycrystalline substrate, the fracture strength in a stud-pull test should be in the range of 70 MPa to 90 MPa.

The stud-pull test involves using an adhesive to attach two stud pins to the surfaces of the first and second semiconductor substrates of a bonded semiconductor substrate, and then pulling the stud pins in a direction perpendicular to the bonded interface to fracture the bonded semiconductor substrate. This test makes it possible to measure the fracture strength at fracture and to evaluate whether the bonded semiconductor substrate fractured in the first semiconductor substrate, the second semiconductor substrate, or the bonded interface. Note that if the strength of the first and second semiconductor substrates is high and the bonding strength of the bonded interface is also high, fracture may occur due to the adhesive. However, because the high-strength adhesive is used, if fracture occurs due to the adhesive, it can be said that the bonded semiconductor substrate itself has sufficient strength without any problems.

### (Height of an Undulation at the Bonded interface)

During the manufacturing process of a bonded semiconductor substrate, elements in the amorphous layer are recrystallized by a heat treatment step described below. During this step, the elements migrate and recrystallize, forming an undulating bonded interface. The undulations at the bonded interface increase the bonded area between the first semiconductor substrate and the second semiconductor substrate at the bonded interface, enhanching the bonding strength. As a result, delamination at the bonded interface of the bonded semiconductor substrates is prevented.

The height of the undulations at the bonded interface is 1.5 nm or more. The height of 1.5 nm or more increases the bonding area between the first and second semiconductor substrates, strengthening the bonding strength at the bonded interface and making the bonding strength at the bonded interface greater than the fracture strength of the first and second semiconductor substrates. While there is no particular upper limit to the height of the undulations, the height of 5 nm sufficiently increases the bonding strength, making the bonding strength at the bonded interface significantly greater than the fracture strength of the first and second semiconductor substrates, thereby reliably preventing delamination at the bonded interface.

### [Method for Manufacturing Bonded Semiconductor Substrate]

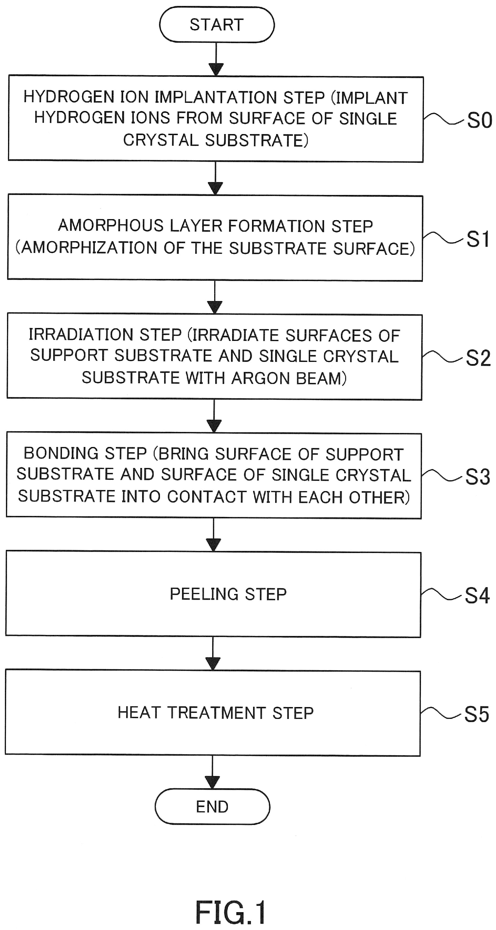

Next, as an example of a method for manufacturing a bonded semiconductor substrate comprising a first semiconductor substrate and a second semiconductor substrate according to the present invention, a method for manufacturing a bonded semiconductor substrate 10 in which the support substrate 11 (second semiconductor substrate) is a polycrystalline SiC substrate and the single-crystal substrate 13 (first semiconductor substrate) is a single-crystal 4H-SiC substrate will be described. Here, with reference to the flow diagram showing an example of a method for manufacturing a bonded semiconductor substrate shown in FIG. 1, the manufacture of the bonded semiconductor substrate 10 using a technique for delaminating the single-crystal substrate 13 by ablation of hydrogen atoms is described below.

First, the support substrate 11 and the single crystal substrate 13 are prepared. The support substrate 11 and the single crystal substrate 13 can be obtained with their bonding surfaces planarized. Planarization may be performed by grinding or cutting, or by CMP. Alternatively, the surfaces to be bonded may be planarized manually.

### <Hydrogen Ion Implantation Step (Step S0)>

In step S0 of FIG. 1, a hydrogen ion implantation step is performed in which hydrogen ions are implanted into the single crystal substrate 13 from the bonding target surface 13a of the single crystal substrate 13. When hydrogen ions are implanted into the single crystal substrate 13, they reach a depth corresponding to the incident energy and become highly concentrated. As a result, a hydrogen-implanted layer 15, indicated by the dotted line, is formed at a predetermined depth from the bonding target surface 13a, as shown in the side view schematic diagram of FIG. 3. For example, the hydrogen-implanted layer 15 is formed at a depth of approximately 0.6 µm from the bonding target surface 13a.

The helium-implanted layer may be formed by ion implantation of helium instead of hydrogen. Even if the implanted layer is formed by ion implantation of hydrogen and helium alternately, a similar delamination effect can be expected in the peeling step described below.

The hydrogen ion implantation step is not essential to the present invention. The present invention may be carried out using a single crystal substrate 13 after hydrogen ion implantation, for example, purchased.

The hydrogen ion implantation step can be employed, for example, when the second semiconductor substrate is a SiC polycrystalline substrate and the first semiconductor substrate is a SiC single crystal substrate, or when the first semiconductor substrate is a Si substrate and the second semiconductor substrate is a Si substrate, and can be performed before or after the amorphous layer formation step described below.

### <Amorphous Layer Forming Step (Step S1)>

This step is a step of amorphizing at least one of the surface of the first bonding surface, which is the surface where the first semiconductor substrate is bonded to the second semiconductor substrate, or the surface of the second bonding surface, which is the surface where the second semiconductor substrate is bonded to the first semiconductor substrate, to form an amorphous layer. That is, this step forms an amorphous layer on at least one of the bonding target surface 11a and the bonding target surface 13a. Examples of possible cases include forming an amorphous layer on the bonding target surface 11a but not on the bonding target surface 13a, forming an amorphous layer 12 on the bonding target surface 13a without forming an amorphous layer on the bonding target surface 11a, or forming an amorphous layer on both the bonding target surface 11a and the bonding target surface 13a.

The amorphous layer aims to increase the bonding area between single crystal substrate 13 and support substrate 11 at bonding interface 14 by forming undulating bonding interface 14, thereby making the bonding strength between single crystal substrate 13 and support substrate 11 stronger than the fracture strength of single crystal substrate 13. Therefore, when forming an amorphous layer on bonding target surface 11a, it is preferable to form the amorphous layer on the entire surface of bonding target surface 11a, and when forming an amorphous layer on bonding target surface 13a, it is preferable to form amorphous layer 12 on the entire surface of bonding target surface 13a.

The thickness of the amorphous layer formed in the amorphous layer formation step is 5 nm or more. By making the thickness of the amorphous layer 5 nm or more, a bonded interface 14 with large undulations can be formed by the heat treatment step, and the bonding area between the single crystal substrate 13 and the support substrate 11 at the bonded interface 14 can be further increased, so that the bonding strength between the single crystal substrate 13 and the support substrate 11 can be made stronger than the fracture strength of the single crystal substrate 13.

There is no particular upper limit to the thickness of the amorphous layer, but depending on the performance of the equipment used to form the amorphous layer, a rough upper limit of the amorphous layer thickness is, for example, 50 nm.

As an example, the following describes a case where an amorphous layer 12 is formed on the bonding target surface 13a without forming an amorphous layer on the bonding target surface 11a.

In FIG. 1, in step S1, an amorphous layer 12 is formed on the bonding target surface 13a of the single crystal substrate 13. The amorphous layer 12 has no regularity in the arrangement of its constituent elements; in other words, it is not crystalline, and it is sufficient that the elements are arranged irregularly.

To form the amorphous layer 12, it is preferable to employ plasma impantation using a plasma impantation machine. As shown in FIG. 4, the plasma impantation machine can effectively form the amorphous layer 12 on the bonding target surface 13a. Furthermore, using a plasma impantation machine makes it possible to easily control the plasma impantation depth, etc., by adjusting the acceleration voltage, dose, etc.

Examples of ion elements implanted by a plasma implantation machine include silicon (Si), carbon (C), helium (He), neon (Ne), argon (Ar), xenon (Xe), hydrogen (H), nitrogen (N), phosphorus (P), boron (B), and aluminum (Al). As a result, when an amorphous layer is formed by a plasma implantation machine, at least one of silicon (Si), carbon (C), helium (He), neon (Ne), argon (Ar), xenon (Xe), hydrogen (H), nitrogen (N), phosphorus (P), boron (B), and aluminum (Al) may be present in the amorphous layer.

As an example of an embodiment of the amorphous layer formation step of the present invention, consider a case where nitrogen (N) is used as the plasma element to form amorphous layer 12. Specifically, single crystal substrate 13 is placed in a plasma implantation machine, and nitrogen (N) ions are implanted into the surface of bonding target surface 13a of single crystal substrate 13 using the plasma implantation machine, thereby forming amorphous layer 12 in the surface layer of single crystal substrate 13 (FIG. 4).

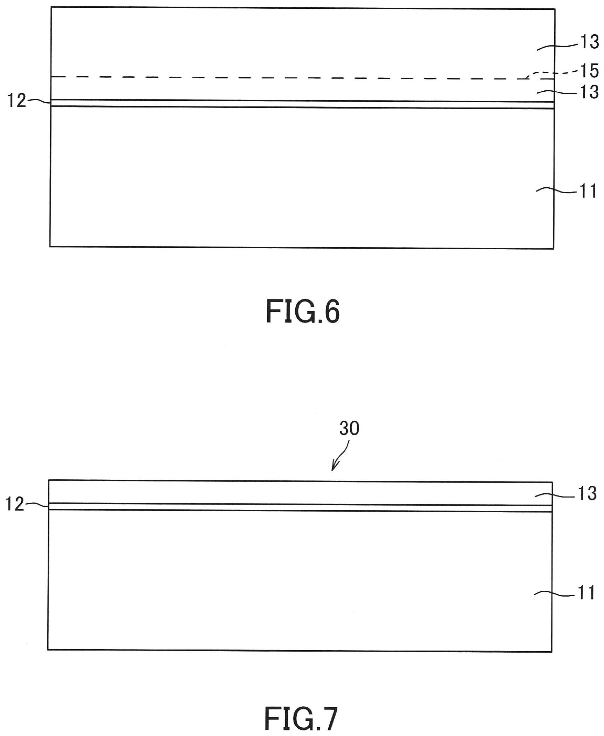

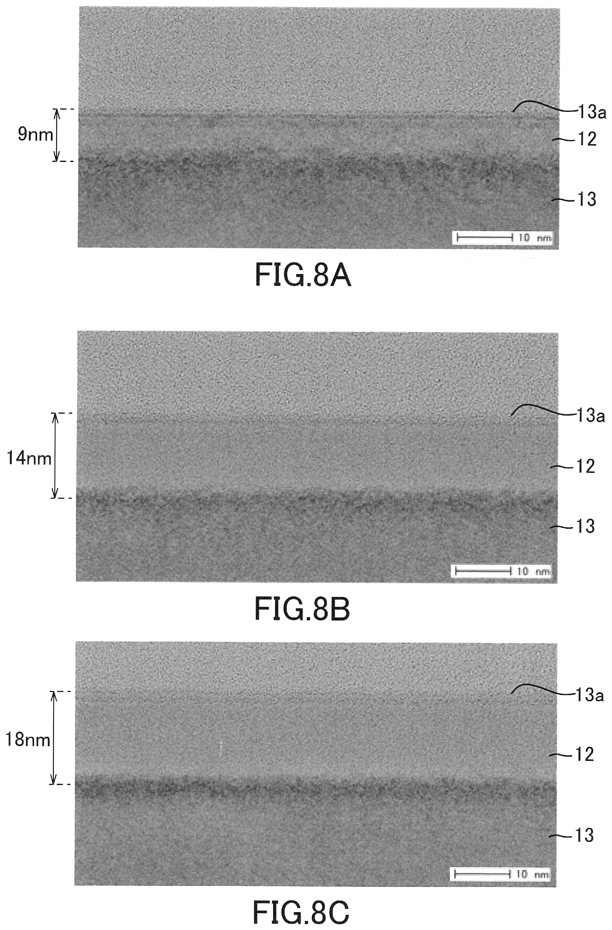

FIGS. 8A to 8C show transmission electron microscope (TEM) images of the cross section of amorphous layer 12 formed by plasma implantation of nitrogen (N) into bonding target surface 13a of single crystal substrate 13 at room temperature. In all of FIGS. 8A to 8C, the implantation temperature was room temperature, the voltage was 6 kV, and the dose was 7.0×10¹⁴ /cm² for FIG. 8A, 3.5×10¹⁵ /cm² for FIG. 8B, and 7.0×10¹⁵ /cm² for FIG. 8C.

Because the amorphous layer 12 has no regularity in the elemental arrangement and is a layer in which the elements are arranged irregularly, the contrast in TEM observation images is different from that of the single crystal substrate 13, in which the elements are arranged regularly, and the amorphous layer 12 appears lighter in color than the single crystal substrate 13. Furthermore, the amorphous layer 12 has a uniform color due to the lack of diffraction contrast caused by crystals, allowing the amorphous layer 12 and the single crystal substrate 13 to be visually distinguished from each other.

The region at a predetermined depth from the bonding target surface 13a in Figures 8A to 8C is a region with a uniform, lighter color than the single crystal substrate 13, and this region is the amorphous layer 12 formed by nitrogen (N) plasma implantation. The depth of the amorphous layer 12 is 9 nm to 18 nm, and it is observed that the amorphous layer tends to become deeper as the nitrogen (N) dose increases.

The acceleration voltage when plasma implantation of nitrogen (N) can be set within the range of 0.1 to 1000 kV. For example, the plasma implantation step may be performed by controlling the acceleration voltage, etc., so that the nitrogen (N) concentration is maximized at the bonding target surface 13a of the single crystal substrate 13.

By forming such an amorphous layer 12 in advance, the elements in the amorphous layer 12 can move more easily in the subsequent heat treatment step, thereby forming undulating bonded interface 14.

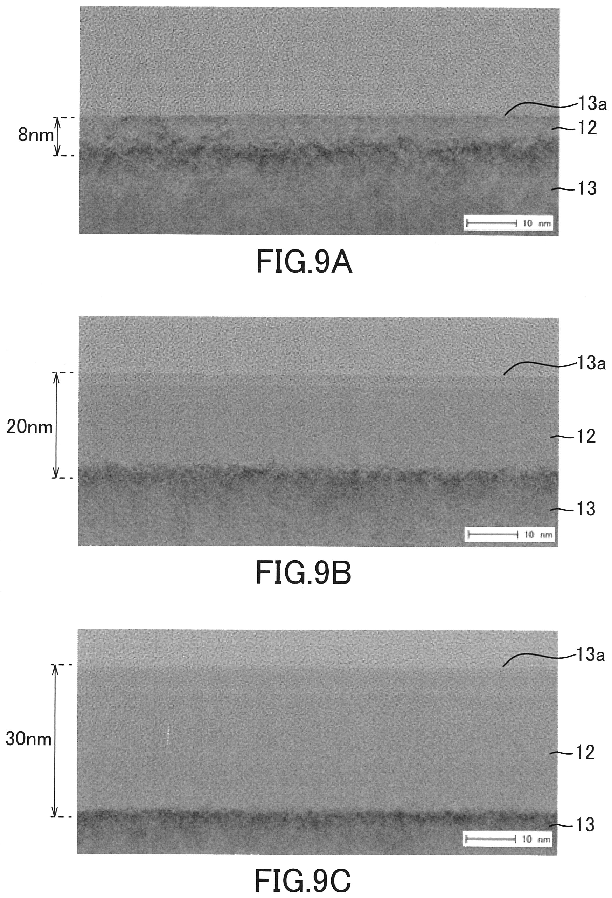

Figures 9A to 9C also show transmission electron microscope (TEM) images of a cross section of amorphous layer 12 formed by plasma implantation of phosphorus (P) into the bonding target surface 13a of the single crystal substrate 13 at room temperature. In all of Figures 9A to 9C, the implantation temperature was room temperature, the voltage was 10 kV, and the dose was 3.6 x 10¹⁴/cm² for Figure 9A, 3.6 x 10¹⁵/cm² for Figure 9B, and 3.6 x 10¹⁶/cm² for Figure 9C.

The region at a predetermined depth from the bonding target surface 13a in Figures 9A to 9C is a region of uniform pale color compared to the single crystal substrate 13, and this region is amorphous layer 12 formed by phosphorus (P) plasma implantation. The depth of amorphous layer 12 is 8 nm to 30 nm, and it is observed that the amorphous layer tends to become deeper as the phosphorus (P) dose increases.

Note that the method for forming amorphous layer 12 is not limited to plasma implantation using a plasma implantation machine. For example, the amorphous layer 12 may be formed on the bonding target surface 13a using an ion implantation device or the like, with appropriate conditions set to form the amorphous layer 12. However, plasma implantation, due to its high element impantation current density, can shorten the impantation time for the same amount of element, making it a highly productive implantation method. Therefore, employing plasma implantation allows for efficient formation of a sufficiently thick amorphous layer 12.

### <Irradiation Step (Step S2)>

This step is performed after the amorphous layer formation step and before the bonding step, by irradiating the first bonding target surface or the second bonding target surface with an argon beam. That is, this step irradiates the bonding target surfaces 11a or 13a with an argon beam. Alternatively, the argon beam may be irradiated on both the bonding target surfaces 11a and 13a.

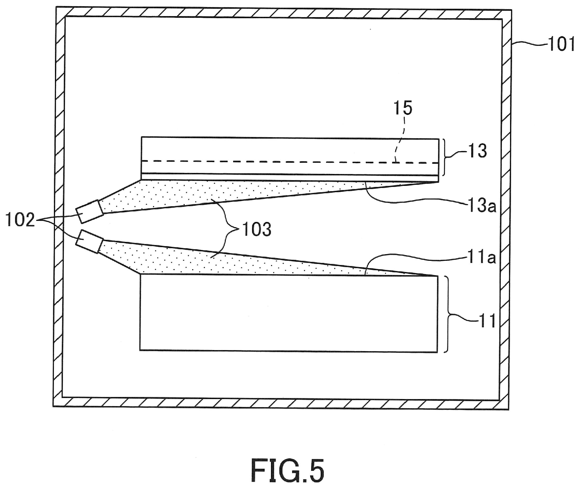

The irradiation step is performed in step S2 of Figure 1. As shown in Figure 5, the single crystal substrate 13 and the support substrate 11 are placed in a chamber 101. Next, the relative positions of the single crystal substrate 13 and the support substrate 11 are aligned. This alignment is performed so that the two substrates can be brought into contact with each other in the correct positional relationship during the bonding step described below. Next, a vacuum is created inside the chamber 101. The degree of vacuum inside the chamber 101 may be, for example, approximately 1×10⁻⁴ to 1×10⁻⁶ Pa.

Next, a neutral element beam 103 of argon (Ar) is irradiated onto the bonding target surfaces 11a of the support substrate 11 and 13a of the single crystal substrate 13 using a fast atomic beam gun (FAB gun) 102. The neutral element beam of argon (Ar) is uniformly irradiated onto the entire surfaces of the bonding target surfaces 11a and 13a. This removes oxide films and adsorption layers from the bonding target surfaces 11a and 13a, exposing bonds. This state is called an activated state. Furthermore, because the irradiation step is performed in a vacuum, the bonding target surfaces 11a and 13a are not oxidized and remain active.

The irradiation step is not essential and can be omitted if the bonded semiconductor substrate 10 can be successfully formed by bonding the single crystal substrate 13 and the support substrate 11 using the bonding step described below. The irradiation step involves colliding atoms or molecules with the surface to remove oxides and adsorption layers through a sputtering phenomenon. However, this step can be replaced by a step in which surface contaminants are chemically reacted with reactive gases to remove them through etching. Furthermore, if the adsorption material is easily sublimated, it can be removed by simply applying heat or light. These steps can be used instead of the irradiation step to remove oxide films and adsorption layers from the bonding target surfaces, exposing bonds.

### <Bonding Step (Step S3)>

This step, which follows the amorphous layer formation step, bonds the first bonding target surface and the second bonding target surface to form a bonded substrate having a bonded interface.

In step S3 of FIG. 1, the bonding step is performed. In this bonding step, the bonding target surface 11a of the support substrate 11 and the bonding target surface 13a of the single-crystal substrate 13 are brought into contact in a vacuum within the chamber 101. The active bonds present on the bonding target surface 11a and the bonding target surface 13a bond together, bonding the support substrate 11 and the single-crystal substrate 13. This forms a bonded structure between the support substrate 11 and the single-crystal substrate 13, as shown in the schematic diagram of FIG. 6.

### < Peeling Step (Step S4)>

This step can be performed after the bonding step and before the heat treatment step. The application of heat during the peeling step forms a microbubble layer in the hydrogen-implanted layer 15, and the single-crystal substrate 13 is partially delaminate using the microbubble layer as the peeling surface. In other words, the single-crystal substrate 13 is delaminated using the hydrogen-implanted layer 15 on which the microbubble layer has formed.

In step S4 of Figure 1, a peeling step is performed. Specifically, the bonded support substrate 11 and single-crystal substrate 13 are heated to approximately 800°C or higher. The peeling atmosphere may be at least one of an inert gas atmosphere such as argon (Ar) or nitrogen (N), or a vacuum. The degree of vacuum may be, for example, approximately 1 x 10⁻⁴ to 1 x 10⁻⁶ Pa. Peeling may be performed using rapid thermal annealing (RTA) or a furnace. This allows the single-crystal substrate 13 to be separated at the hydrogen-implanted layer 15. As a result, as shown in the schematic diagram of Figure 7, a bonded substrate 30 can be formed in which a thin single crystal substrate 13, e.g., 0.6 µm thick, is bonded on the support substrate 11.

### <Heat Treatment Step (Step S5)>

This step involves heat-treating the bonded substrate to increase the undulation height of the bonded interface to 1.5 nm or more. The bonded semiconductor substrate 10 is completed by the heat treatment step.

The heat treatment step is performed in step S5 of FIG. 1. In this heat treatment step, the bonded substrate 30, which includes the support substrate 11, the amorphous layer 12, and the single crystal substrate 13, is heat-treated. The heat treatment temperature may be set so that the temperature of the bonded substrate 30 is 1100°C to 2200°C, preferably 1600°C to 1800°C, and more preferably approximately 1700°C. By setting the heat treatment temperature (i.e., the temperature of the bonded substrate 30) to 1100°C to 2200°C, it is possible to easily achieve an undulation height of 1.5 nm or more at the bonded interface. If the heat treatment temperature is less than 1100°C, the undulation height may be less than 1.5 nm. If the heat treatment temperature exceeds 2200°C, the substrate material may sublimate, causing roughness on the surface of the bonded substrate 30.

The atmosphere for the heat treatment may be at least one of an inert gas atmosphere such as argon (Ar) or nitrogen (N), or a vacuum atmosphere. The degree of vacuum may be, for example, about 1 x 10⁻⁴ to 1 x 10⁻⁶ Pa. The heat treatment step may be performed in the furnace in which the peeling step was performed. Furthermore, if the heat treatment temperature is maintained for 1 minute or more, the height of the undulations at the bonded interface can be made 1.5 nm or more. There is no particular upper limit to the holding time of the heat treatment temperature, but in consideration of manufacturing efficiency, the upper limit of the holding time may be set to, for example, 100 hours. For example, the holding time at the heat treatment temperature can be set between 1 minute and 10 hours.

Furthermore, although the height of the undulations at the bonded interface varies depending on the thickness of the amorphous layer, the heat treatment temperature, and the holding time at the heat treatment temperature, setting the upper limit of the undulation height to 5 nm sufficiently achieves the objectives of the present invention.

The bonded semiconductor substrate 10 manufactured by the above manufacturing method has a fracture strength of 70 MPa or more in a direction perpendicular to the bonded interface 14, as measured by a stud-pull test. When the fracture strength of the SiC single crystal substrate alone is measured by a stud-pull test, it is less than 70 MPa. In other words, a fracture strength of 70 MPa or more indicates that the bonded semiconductor substrate 10 does not peel at the bonded interface 14, but rather indicates that the SiC single crystal substrate fractures while the bonded interface 14 remains bonded.

A fracture strength of 70 MPa or more in a stud-pull test prevents delamination at the bonded interface during the step of growing an epitaxial film on the bonded semiconductor substrate 10 and subsequently manufacturing a semiconductor device. This also prevents delamination at the bonded interface even after electronic circuits are formed on the bonded semiconductor substrate 10, the substrate is cut into chips, and the chips are incorporated into mobile phones, home appliances, and industrial equipment.

Since a fracture strength of 70 MPa or more in a stud-pull test prevents delamination at the bonded interface, there is no particular upper limit to the fracture strength. However, when the bonded semiconductor substrate 10 is a substrate formed by bonding a SiC single crystal substrate and a SiC polycrystalline substrate, the fracture strength in a stud-pull test falls within the range of 70 MPa to 90 MPa.

### <Modifications>

The above describes one embodiment of the present invention in detail, but these are merely examples and do not limit the scope of the present invention. For example, as described below, the present invention includes various modifications and variations of the specific examples described above.

The element used to form the amorphous layer 12 may be silicon (Si) as an element other than nitrogen (N) or phosphorus (P). In this case, the elemental composition ratio of silicon at the bonded interface 14 will be higher than that of carbon, and the bonded interface 14 will be composed of silicon rich SiC. For example, the silicon to carbon composition ratio at the bonded interface 14 will be Si:C = 50-60 atomic %: 40-50 atomic %.

The element used to form the amorphous layer 12 may also be carbon (C). In this case, the elemental composition ratio of carbon at the bonded interface 14 will be higher than that of silicon, and the bonded interface 14 will be composed of carbon-rich SiC. For example, the carbon composition ratio will be in the range of 50-60 atomic %.

The element used to form the amorphous layer 12 may also be an element that is unlikely to act as a carrier and has a high efficiency in forming the amorphous layer 12. For example, at least one of a rare gas such as helium (He), neon (Ne), argon (Ar), or xenon (Xe), or hydrogen (H), may be used.

The element used to form amorphous layer 12 may be an element that easily functions as a carrier and easily amorphizes. For example, in addition to the already mentioned nitrogen (N) and phosphorus (P), boron (B) and aluminum (Al) may be used. At least one of these four elements may be used. In particular, when an element with a large mass such as phosphorus (P) is used, the crystal structure is more easily destroyed and the material is more easily made amorphous than when an element with a small mass is used.

The amorphous layer formation step (step S1) may be performed between the peeling step (step S4) and the heat treatment step (step S5). In this case, ions may be implanted from the surface of the single crystal substrate 13 toward the bonded interface by ion implantation. In this case, various parameters of the ion implantation conditions, such as acceleration energy and incident angle, may be set so that the ion concentration is maximized near the bonded interface. For example, a multi-stage implantation method may be used in which ions are implanted multiple times while changing the acceleration energy, thereby controlling the ion concentration to be maximized near the bonded interface.

Furthermore, in the present invention, after the heat treatment step (step S5), a single crystal layer of a required thickness can be formed by epitaxial growth on the single crystal substrate 13. This epitaxial layer becomes the region where various elements, such as semiconductor elements that are components of electronic circuits, are formed. The thickness of the epitaxial layer required to form various elements is not particularly limited, but is, for example, approximately 5 µm or more when the epitaxial layer is SiC single crystal.

Furthermore, when SiC is used for the single crystal substrate 13, it is not limited to 4H-SiC single crystal. Various polytypes of SiC single crystal, such as 3C-SiC and 6H-SiC, can be used as the single crystal substrate 13. Furthermore, when polycrystalline SiC is used for the support substrate 11, it is not limited to 3C-SiC polycrystalline. Various polytypes of polycrystalline SiC can be used.

### Examples

The present invention will be described in more detail below using examples, but the present invention is not limited to these examples.

### [Example 1]

### <Manufacture of Bonded Semiconductor Substrate 10>

A 4H-SiC single crystal substrate with a diameter of 6 inches, fabricated by sublimation, was used as the single crystal substrate 13. A 3C-SiC polycrystalline substrate with a diameter of 6 inches, obtained by depositing polycrystalline SiC by chemical vapor deposition, was used as the support substrate 11. First, prior to the hydrogen ion implantation step, the bonding target surfaces 11a and 13a of the single crystal substrate 13 and the support substrate 11 were mirror-polished and cleaned.

### (Hydrogen Ion Implantation Step S0)

Hydrogen ions were implanted into the bonding target surface 13a of the single crystal substrate 13 at a depth of approximately 0.6 µm from the bonding target surface 13a, forming a hydrogen-implanted layer 15. This layer is delaminated by the formation of microbubbles due to the heat applied in the subsequent peeling step S4.

### (Amorphous Layer Forming Step S1)

The single crystal substrate 13 was placed in a plasma implantation machine (manufactured by ULVAC), and nitrogen (N) ions were implanted into entire of the bonding target surface 13a of the single crystal substrate 13, forming an amorphous layer 12 with a thickness of 6 nm over entire of the bonding target surface 13a. The plasma implantation conditions were as follows: N₂ gas, constant plasma power output for generating nitrogen ions, room temperature (23°C), 6 kV acceleration voltage for implanted ions, and a dose of 5.5 × 10¹⁴/cm².

### (Irradiation Step S2)

The bonding target surfaces 11a and 13a were mirror-polished and cleaned. Next, the bonding target surfaces 11a and 13a were irradiated with an argon beam.

Specifically, as shown in FIG. 5, the single crystal substrate 13 and the support substrate 11 were placed in the chamber 101, and the relative positions of the single crystal substrate 13 and the support substrate 11 were aligned. Next, the chamber 101 was evacuated to a vacuum level of 1×10⁻⁴ to 1×10⁻⁶ Pa.

Next, the bonding target surface 11a of the support substrate 11 and the bonding surface 13a of the single crystal substrate 13 were irradiated with a neutral argon beam using the FAB gun 102. The neutral argon beam was uniformly irradiated over the entire surfaces of the bonding target surface 11a and the bonding target surface 13a.

### (Bonding Step S3)

After the irradiation step, the bonding target surface 11a of the activated support substrate 11 and the bonding target surface 13a of the single crystal substrate 13 were brought into contact with each other in the chamber 101 while maintaining a vacuum. Further pressure was applied to obtain a bonded substrate of the support substrate 11 and the single crystal substrate 13.

### (Peeling Step S4)

The bonded substrate was heated in an inert atmosphere filled with nitrogen gas using a furnace. The single crystal substrate 13 was peeled at the hydrogen-implanted layer 15 to form a bonded substrate 30 bonded to a thin single crystal substrate 13 with a thickness of 0.6 µm.

### (Heat Treatment Step S5)

After the peeling step, the bonded substrate 30 was heated at 1700°C in an inert atmosphere filled with argon gas in the furnace to recrystallize the amorphous layer 12, thereby obtaining a bonded semiconductor substrate 10.

### <Evaluation of Bonded Semiconductor Substrate 10>

### (Measurement of the Height of an Undulation at the Bonded Interface 14)

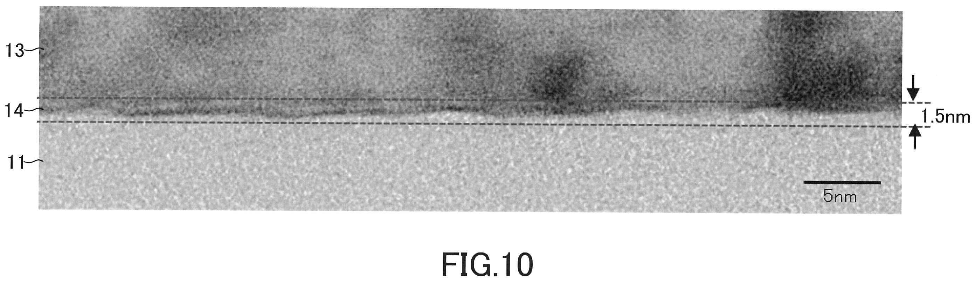

The bonded semiconductor substrate 10 was cut so that the height of the undulation at the bonded interface 14 between the support substrate 11 and the single crystal substrate 13 could be confirmed. The cut surface was observed using a transmission electron microscope (TEM). Figure 10 shows a TEM image of the cut surface. The TEM observation direction of the cross section was along the Miller indices [1-100]. Figure 10 shows that the support substrate 11 and the single crystal substrate 13 were bonded together completely and without gaps at the bonded interface 14. The bonded interface 14 was not linear, but rather curved, with a wide undulation, as shown by the dotted line in Figure 10. The width indicated by the dotted line is the width of the undulations at the bonded interface 14. If this is taken as the height of an undulation, the height was 1.5 nm.

The undulation height at the bonded interface 14 was calculated as follows: First, six points were selected from the 50 nm-long undulating curve of the bonded interface 14 in the TEM image of the cut surface: three points at the top of the undulations and three points at the bottom of the undulations. Next, the slope was calculated using the least-squares method for these six points. With the slope fixed, the line connecting the top three points of the undulations and the line connecting the bottom three points were calculated using the least-squares method. The difference between the intercepts was used as the height of an undulation.

### (Measurement of Fracture Strength by Stud-Pull Test)

A stud-pull test was conducted to confirm that the peel strength of the bonded interface 14 of the bonded semiconductor substrate 10, which has undulating bonded interface 14 observed in Figure 10, is greater than the fracture strength of the single crystal substrate 13.

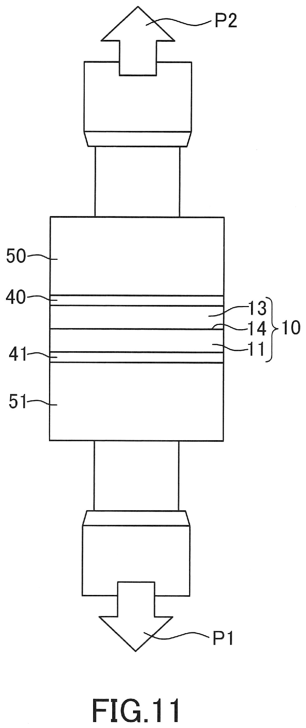

First, a chip measuring 10 mm long and 10 mm wide was cut from the bonded semiconductor substrate 10 to serve as a test specimen. As shown in Figure 11, the surface of the single crystal substrate 13 and the stud pin 50 of the test specimen were bonded with adhesive layer 40, and the surface of the support substrate 11 and the stud pin 51 were bonded with adhesive 41. After the adhesive layer 40 and 41 hardened, a precision universal testing machine AGX-50kNVD (manufactured by Shimadzu Corporation) was used to pull the stud pins 50 and 51 in directions P1 and P2, respectively, to pull the bonded semiconductor substrate 10 in a direction perpendicular to the bonded interface 14 until it broke. Eight test specimens were prepared, and the stud-pull test was performed eight times. The load at which the bonded semiconductor substrate 10 broke in the stud-pull test was measured as the maximum point load. The maximum point stress was calculated by dividing the maximum point load by the area of the surface where the stud pin 50 contacted the adhesive layer 40, and the average of the maximum point stresses measured over the eight tests was taken as the fracture strength. It was also confirmed whether the fracture occurred in the support substrate 11, the bonded interface 14, or the single crystal substrate 13.

For comparison, a similar stud-pull test was performed using only the single crystal substrate 13, breaking the single crystal substrate 13. The average of the maximum point stresses calculated over the eight measurements was taken as the fracture strength.

### (Results of Stud-Pull Test)

The bonded semiconductor substrate 10 fractured at the support substrate 11. Furthermore, the bonded interface 14 after the stud-pull test maintained a good bond without peeling. The fracture strength of the bonded semiconductor substrate 10 was 75.0 MPa. The in-plane distribution of the maximum point stress of the bonded semiconductor substrate 10 was comparable between the center and the edge of the substrate. No decrease in the maximum point stress was observed depending on the substrate location.

On the other hand, the fracture strength of the single crystal substrate 13 was 64.8 MPa. The fracture strength of the single crystal substrate 13 was lower than that of the bonded semiconductor substrate 10. This is likely because, in the case of the single crystal substrate 13, cracks at the edge of the substrate initiated and extended along the crystal plane, causing fracture.

### [Example 2]

The amorphous layer formation step was carried out under the same conditions as in Example 1, and an amorphous layer 12 having a thickness of 6 nm was formed on the entire surface of the bonding target surface 13a of the single crystal substrate 13, and an amorphous layer having a thickness of 6 nm was formed on the entire surface of the bonding target surface 11a of the support substrate 11. Other steps were performed under the same conditions as in Example 1 to produce a bonded semiconductor substrate.

As in Example 1, the cut surface was observed using a transmission electron microscope (TEM) to measure the height of the undulations at the bonded interface. The height was found to be 3.0 nm. It was confirmed that increasing the thickness of the amorphous layer also increases the height of the undulations.

### <Effects>

In the present invention, by amorphizing one or both of the bonding target surface 11a of the support substrate 11 and the bonding target surface 13a of the single crystal substrate 13, the atoms constituting the substrates become more mobile, forming a bonded interface with an undulation. This increases the bonding area between the support substrate 11 and the single crystal substrate 13, strengthening the bonding strength, and preventing delamination at the bonded interface 14.

### (Summary)

As described above, the present invention provides a bonded semiconductor substrate and a method for manufacturing a bonded semiconductor substrate that can prevent delamination at the bonded interface, and is therefore industrially useful.

### Reference Signs List

10: Bonded Semiconductor Substrate, 11: Support Substrate, 11a: Bonding Target Surface, 12: Amorphous Layer, 13: Single Crystal Substrate, 13a: Bonding Target Surface, 14: Bonded interface, 15: Hydrogen-Implanted Layer, 30: Bonded Substrate, 40: Adhesive Layer, 41: Adhesive Layer, 50: Stud Pin, 51: Stud Pin, 101: Chamber, 102: FAB Gun, 103: Neutral Element Beam, P1: Direction, P2: Direction

## Claims

1. A bonded semiconductor substrate comprising a first semiconductor substrate and a second semiconductor substrate bonded to the first semiconductor substrate via a bonded interface, wherein the height of an undulation at the bonded interface is 1.5 nm or more.

2. The bonded semiconductor substrate of claim 1, wherein a fracture strength in a stud-pull test in a direction perpendicular to the bonded interface is 70 MPa or more.

3. The bonded semiconductor substrate of claim 1, wherein the first semiconductor substrate and the second semiconductor substrate are made of any of silicon carbide (SiC), silicon (Si), carbon (C), gallium nitride (GaN), aluminum nitride (AlN), gallium oxide (Ga₂O₃), and diamond.

4. The bonded semiconductor substrate of claim 1, wherein the first semiconductor substrate is a single-crystal silicon carbide substrate, and the second semiconductor substrate is a polycrystalline silicon carbide substrate.

5. A method for manufacturing a bonded semiconductor substrate comprising a first semiconductor substrate and a second semiconductor substrate in contact with the first semiconductor substrate, comprising:
an amorphous layer forming step of forming an amorphous layer on at least one of a first bonding target surface, which is the surface of the first semiconductor substrate where the first semiconductor substrate is bonded to the second semiconductor substrate, or a second bonding target surface, which is the surface of the second semiconductor substrate where the second semiconductor substrate is bonded to the first semiconductor substrate,
a bonding step of bonding the first bonding target surface and the second bonding target surface to form a bonded substrate having a bonded interface, and
a heat treatment step of heat treating the bonded substrate to set the height of an undulation at the bonded interface to 1.5 nm or more,
wherein the thickness of the amorphous layer formed in the amorphous layer forming step is 5 nm or more.

6. The method for manufacturing a bonded semiconductor substrate according to claim 5, wherein the first semiconductor substrate and the second semiconductor substrate are any of silicon carbide (SiC), silicon (Si), carbon (C), gallium nitride (GaN), aluminum nitride (AlN), gallium oxide (Ga₂O₃), and diamond.

7. The method for manufacturing a bonded semiconductor substrate according to claim 5, wherein the amorphous layer contains at least any of silicon (Si), carbon (C), helium (He), neon (Ne), argon (Ar), xenon (Xe), hydrogen (H), nitrogen (N), phosphorus (P), boron (B), and aluminum (Al).

8. The method for manufacturing a bonded semiconductor substrate according to claim 5, wherein the amorphous layer forming step forms the amorphous layer by performing a plasma impantation step on at least one of the surface of the first bonding target surface or the surface of the second bonding target surface.

9. The method for manufacturing a bonded semiconductor substrate according to claim 5, wherein the heat treatment step is a step of maintaining the temperature of the bonded substrate at 1100°C to 2200°C.

10. The method for manufacturing a bonded semiconductor substrate according to claim 5, comprising an ion implantation step of implanting hydrogen ions or helium ions into the first bonding surface to form an ion-implanted layer inside the first semiconductor substrate before or after the amorphous layer formation step.

11. The method for manufacturing a bonded semiconductor substrate according to claim 10, comprising a peeling step after the bonding step and before the heat treatment step, wherein the peeling step is a step of delaminating a portion of the first semiconductor substrate by using a microbubble layer as a peeling surface, wherein the microbubble layer is formed by heating the ion-implanted layer.
